# FASCICULE DE BREVET EUROPEEN

(11) **EP 1 354 750 B1**
(45) Date de publication et mention de la délivrance du brevet: **21.06.2006**
(21) Numéro de dépôt: 03290888.1
(22) Date de dépôt: 09.04.2003
(51) Int. Cl.: B60K 37/00, H01R 13/631, H05K 7/14, B60K 37/02

(54) **Ensemble d'équipement de véhicule automobile comportant des moyens de connexion électrique améliorés**
Kraftfahrzeugausstattungseinheit mit verbesserten, elektrischen Verbindungsmitteln
Motor vehicle equipment unit with improved electrical connection means

(30) Priorité: 16.04.2002 FR 0204743
(43) Date de publication de la demande: 22.10.2003
(73) Titulaire: Faurecia Industries, 92000 Nanterre (FR)
(72) Inventeur: Roudot, Jean-Luc, 25230 Seloncourt (FR); Bocquet, Denis, 77590 Bois le Roi (FR); Henigue, Christian, 25400 Audincourt (FR)
(74) Mandataire: Domenego, Bertrand

(56) Documents cités:
- EP-A- 0 800 237
- FR-A- 2 436 685
- US-A- 5 836 787

## Description

L'invention se rapporte au domaine des équipements pour véhicules automobiles.

En particulier, l'invention vise un ensemble d'équipement de véhicule automobile comportant :
- une première partie de connexion électrique montée sur une première pièce d'équipement, la première pièce d'équipement comprenant un premier organe de guidage et de positionnement permettant le guidage suivant une direction d'assemblage et le positionnement relatifs de la première partie de connexion électrique sur la première pièce d'équipement,
- une deuxième pièce d'équipement comprenant un deuxième organe de guidage et de positionnement complémentaire du premier permettant le guidage et le positionnement relatifs de la deuxième pièce d'équipement sur la première pièce d'équipement,
- une deuxième partie de connexion électrique complémentaire de la première, montée sur la deuxième pièce d'équipement.

Le montage d'un équipement comportant des connexions électriques sur un autre équipement déjà fixé ou prépositionné sur le véhicule pose d'importants problèmes de manipulation et nécessite des opérations difficilement automatisables. Par exemple, le montage d'un tableau de bord, qui comporte des afficheurs alimentés électriquement, sur la planche de bord, celle-ci étant déjà en place à l'intérieur du véhicule, s'effectue généralement de la façon suivante : l'opérateur approche, par l'intérieur du véhicule, le tableau de bord qui comporte sur sa face arrière un boîtier de connecteur électrique, saisit la contre-partie de connecteur câblée par l'intérieur de la cavité de la planche de bord prévue pour recevoir le tableau de bord; il doit ensuite réaliser l'assemblage des connecteurs tout en maintenant le tableau de bord proche de la cavité réceptrice ou à l'intérieur de celle-ci, la longueur de câble étant prévue avec une faible sur-longeur par rapport à la position assemblée du tableau de bord dans la planche de bord.

Cette manipulation est non seulement complexe, mais non compatible avec la mise en oeuvre d'un procédé d'assemblage automatisé, et constitue par conséquent un obstacle important pour réaliser des gains de productivité.

Un equipement pour véhicules avec les caractéristiques du préambule de la revendication indépendante est connu du document FR-A-2436685

Un but principal de l'invention est de rendre des opérations d'assemblage du type décrit ci-dessus moins pénibles et plus simples pour un opérateur, voire de rendre l'opération automatisable, et de rattraper automatiquement, lors du montage, les jeux de positionnement relatif des pièces de connexion.

A cet effet, suivant l'invention, la deuxième partie de connexion électrique est montée sur la pièce d'équipement correspondante avec un jeu dans au moins une direction sensiblement orthogonale à la direction d'assemblage, et comprend un troisième organe de guidage et de positionnement complémentaire du premier, de sorte que le premier organe de guidage et de positionnement définit une référence unique de positionnement relatif des pièces d'équipement et de positionnement relatif des première et deuxième parties de connexion. Suivant d'autres caractéristiques de l'invention :
- la deuxième partie de connexion est montée sur la deuxième pièce d'équipement avec un jeu dans deux directions sensiblement orthogonales à la direction d'assemblage;
- le jeu dans au moins une direction sensiblement orthogonale à la direction d'assemblage est supérieur à 1,5 mm, de préférence de l'ordre de 2 mm ;
- l'ensemble d'équipement comporte des moyens élastiques de sollicitation de la deuxième partie de connexion vers une position neutre par rapport à la deuxième pièce d'équipement, agissant dans au moins une direction de jeu ;
- les organes de guidage et de positionnement de la deuxième pièce d'équipement et de la deuxième partie de connexion d'une part, et l'organe de guidage et de positionnement de la première pièce d'équipement d'autre part, sont des rails complémentaires s'étendant de façon sensiblement rectiligne suivant la direction d'accouplement des parties de connexion ;
- le rail de la deuxième partie de connexion s'étend sensiblement dans le prolongement du rail de la deuxième pièce d'équipement ;
- la deuxième partie de connexion est rigidement solidaire d'une plaque de circuit imprimé, qui est elle-même montée avec jeu sur la pièce d'équipement correspondante ;
- ladite plaque est une pièce d'aspect, visible depuis l'intérieur du véhicule lorsque l'ensemble est monté sur le véhicule ; et
- l'une au moins des parties de connexion est un boîtier dans lequel sont logés des contacts.

Suivant un premier mode de réalisation de l'invention, les deux parties de connexion sont des boîtiers complémentaires l'un de l'autre, dans chacun desquels sont logés des contacts respectifs, complémentaires de ceux logés dans la contrepartie de boîtier de connexion.

Suivant un deuxième mode de réalisation de l'invention, l'une des parties de connexion est un boîtier dans lequel sont logés des contacts de type à pression, tandis que l'autre des parties de connexion comprend des surfaces conductrices formées sur la plaque de circuit imprimé, lesdites surfaces recevant en appui lesdits contacts de type pression.

Suivant ce mode de réalisation, avantageusement, la troisième forme de guidage et de positionnement est directement formée dans la plaque de circuit imprimé.

L'invention, comme cela sera illustré par la suite, s'applique plus particulièrement à la fixation d'un équipement électrique sur une planche de bord, un panneau de porte, une console centrale, un siège ou encore un pavillon.

Cet équipement électrique peut être constitué, comme cela a déjà été mentionné, d'un tableau de bord, mais également d'un auto-radio, d'une console de commande, ou d'un afficheur.

Des exemples de réalisation de l'invention vont maintenant être décrits en regard des dessins annexés sur lesquels :
- la Figure 1 est une vue schématique en perspective, depuis l'intérieur d'un véhicule, d'une planche de bord et d'une partie de connecteur associée suivant un premier mode de réalisation de l'invention, les deux pièces étant représentées séparées ;
- la Figure 2 est une vue analogue d'un tableau de bord et d'une partie de connecteur associée ;
- la Figure 3A est une vue en coupe dans un plan médian des connecteurs passant par l'axe longitudinal des rails de guidage, de l'ensemble constitué par les pièces représentées sur les Figures précédentes, la planche de bord ainsi que le tableau de bord étant pourvus de leurs connecteurs respectifs, en position pré-assemblée ;
- la Figure 3B est une vue analogue en position assemblée de la planche de bord et du tableau de bord ;
- la Figure 4 est une vue de détail agrandie, dans la région du rail de guidage, d'une partie de la planche de bord de la Figure 1 et d'une partie de connecteur associée suivant un deuxième mode de réalisation de l'invention ; et
- la Figure 5 est une vue analogue d'une partie d'un tableau de bord et dune partie de plaque de circuit imprimé associée suivant le deuxième mode de réalisation de l'invention.

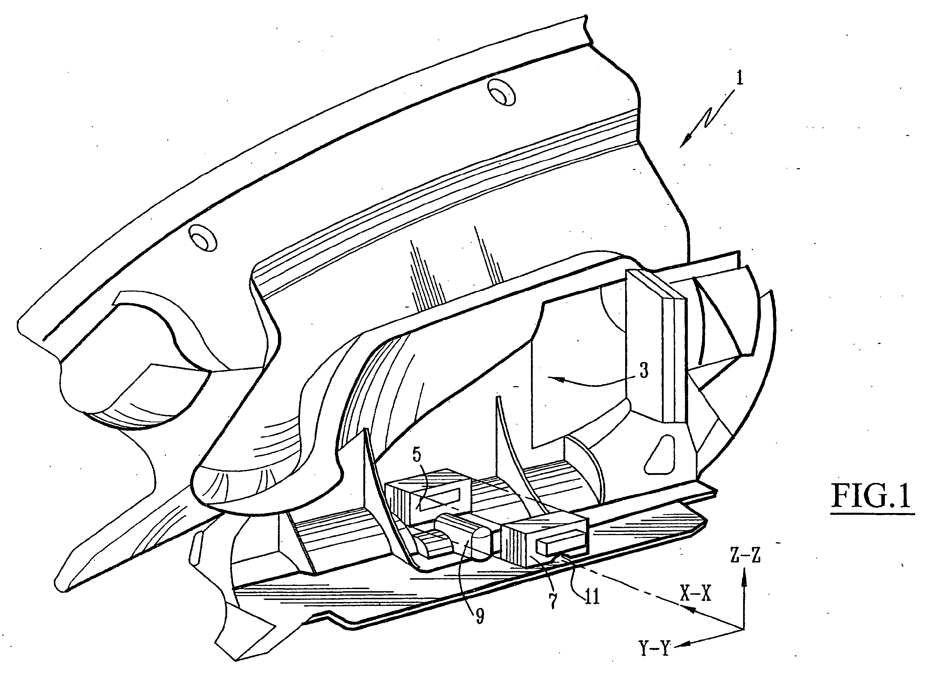

Dans tout ce qui suit, la description sera faite en référence au système d'axes X, Y, Z représenté sur la Figure 1, dans lequel l'axe X-X correspond à l'axe longitudinal du véhicule (horizontal) orienté vers l'avant, l'axe Y-Y correspond à l'axe transversal (horizontal) orienté de droite à gauche, et l'axe Z-Z est l'axe vertical orienté de bas en haut.

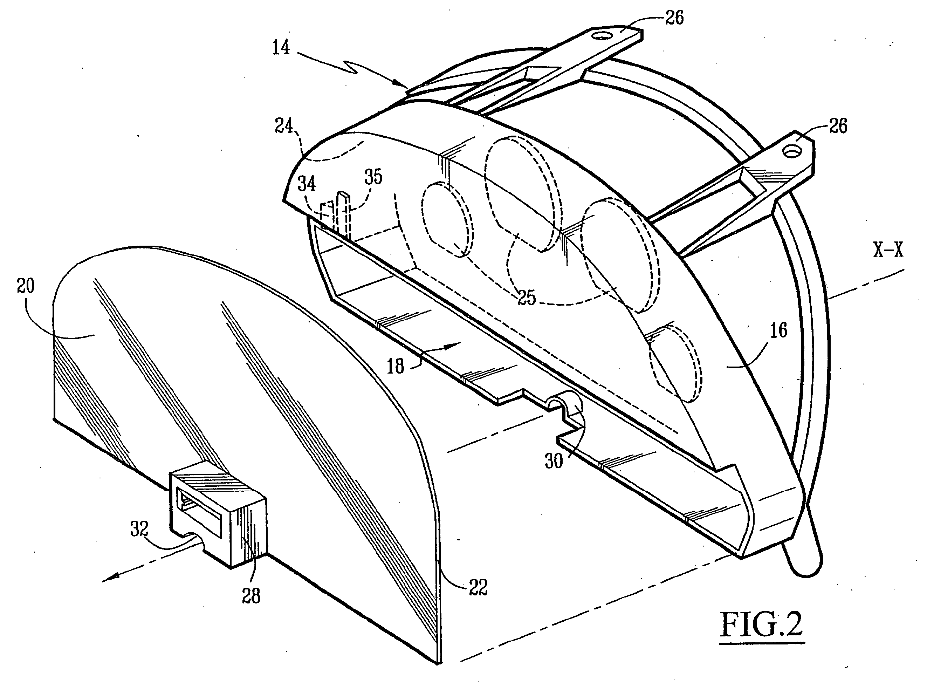

Sur la Figure 1, on a représenté une partie d'une planche de bord 1, dans laquelle est ménagée une cavité 3. La planche de bord 1 constitue une première pièce d'équipement fixée à l'intérieur du véhicule et destinée à recevoir dans sa cavité 3 une deuxième pièce d'équipement constituée par un tableau de bord, qui sera décrit en référence à la Figure 2.

Sur la planche de bord 1, dans une partie inférieure de la cavité 3, est formé un bloc 5 de réception et de fixation d'un connecteur électrique mâle 7. Le connecteur électrique mâle 7 est représenté seul, étant entendu qu'il est en réalité, dans la configuration représentée, câblé. Le faisceau de câbles relié au connecteur électrique mâle 7 n'est pas représenté, et chemine de façon classique depuis le compartiment moteur jusqu'au connecteur 7 placé, lui, dans l'habitacle, en traversant la cavité 3. Le faisceau de câbles pourrait indifféremment venir de la planche de bord 1 elle-même.

Le bloc de réception et de fixation 5 comporte des moyens de fixation du connecteur électrique mâle 7, de type classique, par exemple des moyens d'encliquetage, de vissage, de sertissage ou autres ; ces moyens de fixation n'ont donc pas été représentés.

Un rail 9 venu de moulage avec la planche de bord 1 s'étend, dans l'exemple représenté, suivant l'axe longitudinal X-X, qui définira l'axe d'assemblage des parties de connexion sur les pièces d'équipement, et l'axe d'accouplement des parties de connexion entre elles. Il va de soi que cet axe de référence a été choisi arbitrairement, et que, suivant la nature de l'équipement et son emplacement dans le véhicule, tout autre axe conviendrait à l'illustration de l'invention.

Le rail 9 présente une section transversale en U renversé et coopère avec une encoche 11 de forme complémentaire débouchant sur une face inférieure du connecteur électrique mâle 7. Le rail 9 constitue un organe de guidage et de positionnement du connecteur électrique mâle 7 par rapport à la planche de bord 1 et en particulier par rapport à la cavité 3. Par coopération de l'encoche 11 avec le rail 9, le connecteur électrique mâle 7 est guidé, lorsqu'on le fixe sur la planche de bord 1, longitudinalement jusqu'au bloc 5, et le positionne de façon précise par rapport à celui-ci.

En référence à la Figure 2, on va maintenant décrire la deuxième pièce d'équipement constituée d'un tableau de bord 14 de forme extérieure complémentaire de la cavité 3.

Le tableau de bord 14 comporte par exemple des afficheurs électriques, des cadrans, qui ne sont pas visibles sur la Figure puisque le tableau de bord 14 est orienté de façon à faire apparaître sa partie destinée à coopérer avec la cavité 3 de la planche de bord 1.

De ce côté, le tableau de bord 14 présente une collerette 16 délimitant un réceptacle 18. Ce réceptacle 18 reçoit une plaque de fond 20 dont les bords extérieurs 22 sont prévus pour coïncider, au moins partiellement, avec la surface intérieure 24 de la collerette 16.

La plaque de fond 20 étant constituée d'un circuit imprimé dont la face tournée vers l'intérieur du véhiculé supporte des témoins lumineux, cadrans ou autres afficheurs, elle constitue une pièce d'aspect visible par un utilisateur placé dans l'habitacle du véhicule. Ces témoins lumineux, cadrans, afficheurs, etc., sont visibles depuis l'intérieur du véhicule au travers de fenêtres 25 par rapport auxquelles ils doivent être positionnés relativement précisément. Il est donc important que la plaque de fond 20 soit positionnée relativement précisément dans le réceptacle 18.

Des organes de fixation classiques 26 du tableau de bord 14 sur la planché de bord 1 sont disposés sur la périphérie extérieure du tableau de bord 14.

La plaque de fond 20 est solidaire d'un connecteur électrique femelle 28 complémentaire du connecteur électrique mâle 7 fixé sur la planche de bord 1.

Sur une face interne inférieure de la collerette 16 du tableau de bord 14, est formé un rail 30 rectiligne s'étendant suivant l'axe longitudinal du véhicule X-X. Le rail 30, constituant un deuxième organe de guidage et de positionnement, présente une section transversale en U renversé, dont la partie inférieure creuse est complémentaire du rail 9. Une encoche 32, formée sur une face inférieure du connecteur électrique femelle 28, constitue un troisième organe de guidage et de positionnement (ou rail), également complémentaire du rail 9.

Le verrouillage en position axiale de l'ensemble formé par le connecteur femelle 28 et de la plaque de fond 20 est réalisé par des pattes déformables élastiquement 34, disposées sur les bords intérieurs 24 de la collerette 16 et coopérant avec les bords extérieurs 22 de la plaque de fond 20, ainsi que par des butées axiales 35.

Une fois la plaque 20 fixée sur le tableau de bord 14, comme indiqué précédemment, le rail 32 du connecteur femelle 28 s'étend sensiblement dans le prolongement du rail 30 du tableau de bord, par aboutement des deux rails 30, 32.

La plaque 20 est susceptible de subir de légers déplacements transversaux par rapport au tableau de bord 14 depuis la position neutre ainsi définie.

La plaque 20 présente donc un jeu dans au moins une direction, de préférence deux directions Y-Y, Z-Z, sensiblement orthogonales à la direction de montage X-X dans le réceptacle 18.

Par exemple, le jeu transversal suivant l'axe Y-Y peut être supérieur à 1, 5 mm, de l'ordre de 2 mm.

Le jeu transversal suivant l'axe vertical Z-Z peut être de l'ordre de 0,5 mm.

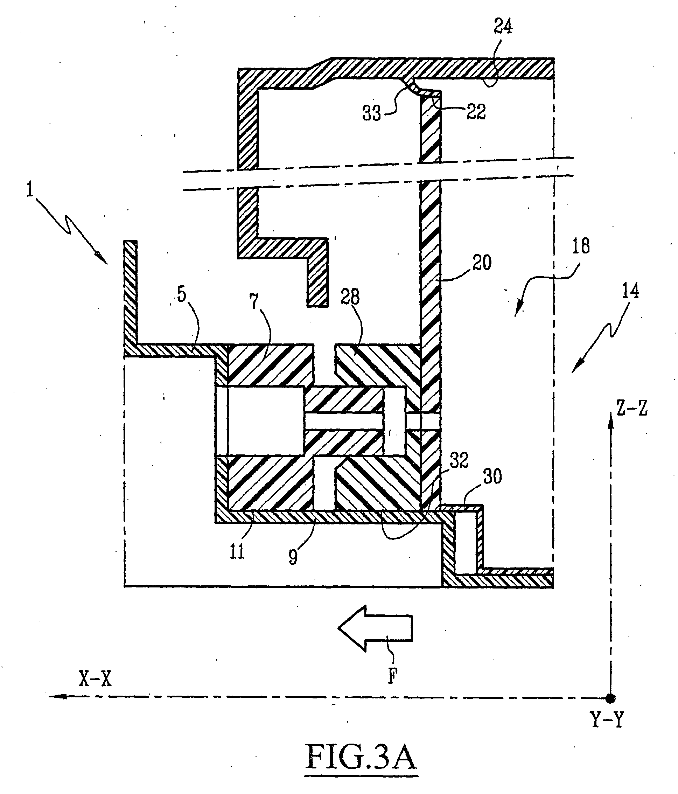

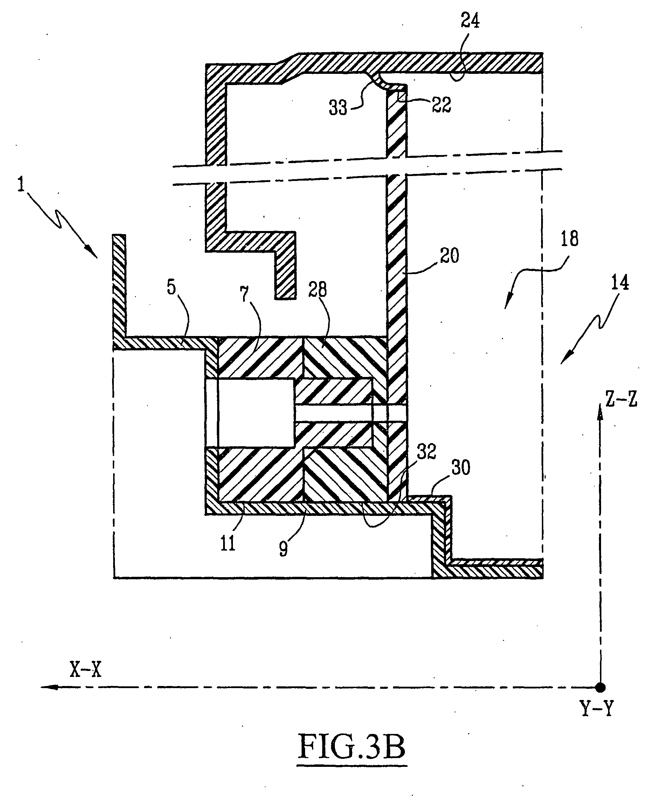

Afin de rappeler la plaque 20 dans la position neutre, centrée par rapport au réceptacle 18, il est prévu des organes élastiques 33 (Figures 3A et 3B), dont l'action de sollicitation est orientée essentiellement dans la direction du jeu entre les bords extérieurs 22 de la plaque 20 et les bords intérieurs 24 de la collerette 16. Ces organes élastiques de rappel 33 peuvent être constitués de languettes en saillie de la collerette 16 vers les bords 22. Dans l'exemple représenté, une telle languette 33 agissant dans la direction du jeu vertical de la plaque 20, sollicite celle-ci vers le bas en pressant son bord inférieur sur le rail 9.

Sur les Figures 3A et 3B, on a représenté chacun des sous-ensembles constitués d'une part par la planche de bord 1 et le connecteur électrique mâle associé 7, et d'autre part par le tableau de bord 14 et le connecteur électrique femelle 28 (et solidairement la plaque de fond 20), chacun des sous-ensembles étant en position assemblée.

On a représenté sur la Figure 3A les deux sous-ensembles en regard l'un de l'autre, dans une position pré-assemblée, de façon que l'on comprenne que le rail 30, par sa surface inférieure, et l'encoche 32 sont adaptés pour coopérer avec le rail 9. En effet, le sous-ensemble assemblé formé par le tableau de bord 14, le connecteur femelle 28 et la plaque de fond 20 peut coulisser sur le rail 9 jusqu'à la position d'insertion complète du tableau de bord 14 dans la cavité 3 d'une part, et du connecteur électrique mâle 7 dans le connecteur électrique femelle 28 d'àutre part.

Pour placer l'ensemble dans sa position complètement assemblée, telle que représentée sur la Figure 3B ,il suffit de pousser la pièce 14 suivant la flèche F jusqu'à l'accouplement complet des parties de connecteur 7, 28.

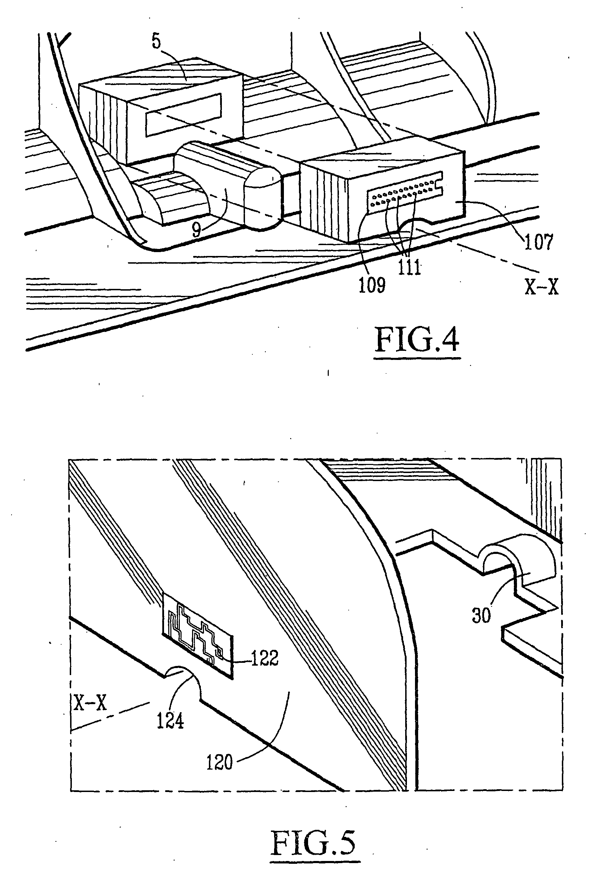

En référence à la Figure 4, on va maintenant décrire un deuxième mode de réalisation de l'invention, dans lequel on substitue une connectique dite « à pression » à la connectique de type « mâle/femelle» qui fait l'objet du premier mode de réalisation de l'invention, décrit en référence aux Figures 1 à 3 (3A et 3B).

Sur cette Figure, on n'a représenté de la planche de bord, à une plus grande échelle que celle de la Figure 1, que la région comportant le bloc de fixation 5 et le rail de guidage 9.

La partie de connexion 107 destinée à venir se fixer sur le bloc 5 est constituée d'un boîtier dans lequel est logé un module porte-contacts 109. Des contacts 111 sont insérés et maintenus dans le module porte-contact 109, lesdits contacts 111 étant de type « à pression », c'est-à-dire qu'ils sont prévus pour coopérer avec une surface conductrice par appui sur celle-ci. Pour cela, les contacts 111 sont montés dans le module porte-contacts 109 de façon à dépasser légèrement dudit module porte-contacts 109 en direction de la contrepartie de connexion, les deux parties de connexion étant, lorsqu'elles sont accouplées, maintenues entre elles avec un effort de serrage adapté.

La contrepartie de connexion associée à la première partie 107 va maintenant être décrite succinctement en référence à la Figure 5.

Sur cette Figure, on a également représenté un tableau de bord du type représenté à la Figure 2, dans sa région comprenant le rail de guidage 30. La deuxième partie de connexion associée à la première partie 107 est constituée essentiellement de pistes conductrices 122 destinées à recevoir en appui les contacts à pression 111, formées sur une plaque de circuit imprimé 120 analogue à la plaque 20 du premier mode de réalisation.

Les moyens de verrouillage et de serrage mutuels des deux parties de connexion 107, 122 n'ont pas été représentés, mais on comprend qu'ils peuvent être de tout type adapté, et agir directement ou indirectement sur les parties de connexion 107, 122.

Une forme de guidage 124 complémentaire du rail 9 est pratiquée directement dans la plaque de circuit imprimé 120 sous la configuration d'une encoche complémentaire du rail 9.

Ce deuxième mode de réalisation illustre que l'invention ne peut être limitée au type le plus courant de connectique, dans lequel les deux parties complémentaires de connexion sont constituées d'un connecteur mâle et d'un connecteur femelle. Au contraire, l'invention se conçoit pour de nombreux types de connecteurs et d'équipements de véhicule.

On conçoit donc que l'organe de guidage et de positionnement 30 permet non seulement de positionner avec une relative précision la partie de connexion électrique 28 ; 122 sur la pièce d'équipement associée 14, mais aussi d'assurer un positionnement précis des parties de connexion 7, 28 ; 107, 122 l'une par rapport à l'autre, et simultanément des pièces d'équipement 1, 14 l'une par rapport à l'autre.

Le montage avec jeu de l'une des parties de connexion sur sa pièce d'équipement permet de garantir à la fois une connexion électrique fiable et le respect des jeux et affleurements entre les différentes pièces.

Ce positionnement est réalisé par rapport à une référence unique constituée par le rail 9, puisque toutes les pièces de l'ensemble sont centrées sur celui-ci. Il en résulte que l'on résout de façon simultanée, par des moyens communs et avec un faible nombre de pièces, les problèmes de positionnement des pièces d'équipement l'une par rapport à l'autre, qui ont un impact important sur l'esthétique de l'intérieur du véhicule, et les problèmes d'alignement des parties de connecteur préalablement à leur accouplement.

## Revendications

1. Ensemble d'équipement de véhicule automobile comprenant :
- une première partie de connexion électrique (7 ; 107) montée sur une première pièce d'équipement (1), la première pièce d'équipement (1) comprenant un premier organe de guidage et de positionnement (9) permettant le guidage suivant une direction d'assemblage (X-X) et le positionnement relatifs de la première partie de connexion électrique (7 ;107) sur la première pièce d'équipement (1),
- une deuxième pièce d'équipement (14) comprenant un deuxième organe de guidage et de positionnement (30)
- une deuxième partie de connexion électrique (28 ;122) complémentaire de la première, montée sur la deuxième pièce d'équipement (14),
**caractérisé en ce que** le deuxième organe de guidage et de positionnement est complémentaire du premier (9) et permet le guidage et le positionnement relatifs de la deuxième pièce d'équipement sur la première pièce d'équipement (1), et **en ce que** la deuxième partie de connexion électrique (28 ;122) est montée sur la pièce d'équipement correspondante (14) avec un jeu dans au moins une direction (Y-Y, Z-Z) sensiblement orthogonale à la direction d'assemblage (X-X), et comprend un troisième organe de guidage et de positionnement (32 ; 124) complémentaire du premier (9), de sorte que le premier organe de guidage et de positionnement (9) définit une référence unique de positionnement relatif des pièces d'équipement (1, 14) et de positionnement relatif des première (7) et deuxième (28 ;122) parties de connexion.

2. Ensemble d'équipement suivant la revendication 1, **caractérisé en ce que** la deuxième partie de connexion (28 ; 122) est montée sur la deuxième pièce d'équipement (14) avec un jeu dans deux directions (Y-Y, Z-Z) sensiblement orthogonales à la direction d'assemblage (X-X).

3. Ensemble d'équipement suivant la revendication 1 ou 2, **caractérisé en ce que** le jeu dans au moins une direction (Y-Y) sensiblement orthogonale à la direction d'assemblage (X-X) est supérieur à 1,5 mm, de préférence de l'ordre de 2 mm.

4. Ensemble d'équipement suivant l'une quelconque des revendications 1 à 3, **caractérisé en ce qu'**il comporte des moyens élastiques (33) de sollicitation de la deuxième partie de connexion (28 ; 122) vers une position neutre par rapport à la deuxième pièce d'équipement (14), agissant dans au moins une direction (Y-Y, Z-Z) de jeu.

5. Ensemble d'équipement suivant l'une quelconque des revendications 1 à 4, **caractérisé en ce que** les organes de guidage et de positionnement (30, 32 ; 124) de la deuxième pièce d'équipement et de la deuxième partie de connexion (28 ; 122) d'une part, et l'organe de guidage et de positionnement (9) de la première pièce d'équipement d'autre part, sont des rails complémentaires s'étendant de façon sensiblement rectiligne suivant la direction d'accouplement des parties de connexion (7, 28 ; 107, 122).

6. Ensemble d'équipement suivant la revendication 5, **caractérisé en ce que** le rail (32 ;124) de la deuxième partie de connexion (28 ; 122) s'étend sensiblement dans le prolongement du rail (30) de la deuxième pièce d'équipement (14).

7. Ensemble d'équipement suivant l'une quelconque des revendications 1 à 6, **caractérisé en ce que** la deuxième partie de connexion (28 ; 122) est rigidement solidaire d'une plaque de circuit imprimé (20 ;120), qui est elle-même montée avec jeu sur la pièce d'équipement correspondante (14).

8. Ensemble d'équipement suivant la revendication 7, **caractérisé en ce que** ladite plaque (20 ; 120) est une pièce d'aspect, visible depuis l'intérieur du véhicule lorsque l'ensemble est monté sur le véhicule.

9. Ensemble d'équipement suivant l'une quelconque des revendications 1 à 8, **caractérisé en ce que** l'une au moins (7, 28 ; 107) des parties de connexion est un boîtier dans lequel sont logés des contacts (111).

10. Ensemble d'équipement suivant la revendication 9, **caractérisé en ce que** les deux parties de connexion (7, 28) sont des boîtiers complémentaires l'un de l'autre, dans chacun desquels sont logés des contacts respectifs, complémentaires de ceux logés dans la contrepartie (7, 28) de boîtier de connexion.

11. Ensemble d'équipement suivant les revendications 7 et 9 prises ensemble, **caractérisé en ce que** l'une (107) des parties de connexion est un boîtier dans lequel sont logés des contacts (111) de type à pression, tandis que l'autre (122) des parties de connexion comprend des surfaces conductrices formées sur la plaque de circuit imprimé (20 ; 120), lesdites surfaces recevant en appui lesdits contacts (111) de type à pression.

12. Ensemble d'équipement suivant la revendication 11, **caractérisé en ce que** la troisième forme de guidage et de positionnement (124) est directement formée dans la partie de connexion correspondant à la plaque de circuit imprimé (120).

## Claims

1. Equipment assembly for a motor vehicle, comprising:
- a first part for electrical connection (7; 107) mounted on a first piece of equipment (1), the first piece of equipment (1) comprising a first guiding and positioning member (9) which permits guiding in an assembly direction (X-X) and relative positioning of the first electrical connection part (7; 107) on the first piece of equipment (1),
- a second piece of equipment (14) comprising a second positioning and guiding member (30),
- a second electrical connection part (28; 122) complementary to the first part, mounted on the second piece of equipment, (14),
**characterised in that** the second guiding and positioning member is complementary to the first member (9) and which permits relative guiding and positioning of the second piece of equipment on the first piece of equipment (1), and **in that** the second electrical connection part (28; 122) is mounted on the corresponding piece of equipment (14) with a clearance in at least one direction (Y-Y, Z-Z) substantially orthogonal to the assembly direction, and comprises a third guiding and positioning member (32; 124) complementary to the first member (9), such that the first guiding and positioning member (9) defines a unique reference for relative positioning of the pieces of equipment (1, 14) and for relative positioning of the first (7) and second (28; 122) connection parts.

2. Equipment assembly as claimed in Claim 1, **characterised in that** the second connection part (28; 122) is mounted on the second piece of equipment (14) with a clearance in two directions (Y-Y, Z-Z) substantially orthogonal to the assembly direction (X-X).

3. Equipment assembly as claimed in Claim 1 or 2, **characterised in that** the clearance in at least one direction (Y-Y) substantially orthogonal to the assembly direction (X-X) is greater than 1.5 mm, preferably of the order of 2 mm.

4. Equipment assembly as claimed in any one of Claims 1 to 3, **characterised in that** it has resilient means (33) for stressing the second connection part (28; 122) towards a neutral position with respect to the second piece of equipment (14), acting in at least one direction (Y-Y, Z-Z) of clearance.

5. Equipment assembly as claimed in any one of Claims 1 to 4, **characterised in that** the guiding and positioning members (30, 32; 124) of the second piece of equipment and of the second connection part (28; 122) on the one hand and the guiding and positioning member (9) of the first piece of equipment on the other hand are complementary rails extending in a substantially rectilinear manner along the direction of coupling of the connection parts (7, 28; 107, 122).

6. Equipment assembly as claimed in Claim 5, **characterised in that** the rail (32; 12) of the second connection part (28; 122) extends substantially in the extension of the rail (30) of the second piece of equipment (14).

7. Equipment assembly as claimed in any one of Claims 1 to 6, **characterised in that** the second connection part (28; 122) is rigidly joined to a printed circuit board (20; 120) which is itself mounted with a clearance on the corresponding piece of equipment (14).

8. Equipment assembly as claimed in Claim 7, **characterised in that** the said board (20; 120) is a visible part which can be seen from the interior of the vehicle when the assembly is mounted on the vehicle.

9. Equipment assembly as claimed in any one of Claims 1 to 8, **characterised in that** at least one (7, 28; 107) of the connections parts is a housing in which contacts (111) are located.

10. Equipment assembly as claimed in Claim 9, **characterised in that** the two connection parts (7, 28) are housings which are complementary to one another, in each of which are accommodated the respective contacts which are complementary to those accommodated in the other part (7, 28) of the connection housing.

11. Equipment assembly as claimed in Claims 7 and 9 taken together, **characterised in that** at least one (107) of the connection parts is a housing in which contacts (111) of the butt contact type are located, whilst the other connection part (122) comprises conductive surfaces formed on the printed circuit board (20; 120), the said surfaces having the said butt-type contacts (111) resting on them.

12. Equipment assembly as claimed in Claim 11, **characterised in that** the third means of guiding and positioning (124) is directly formed in the connection part corresponding to the printed circuit board (120).

## Patentansprüche

1. Ausrüstungseinheit für Kraftfahrzeug mit:
- einem ersten elektrischen Verbindungsteil (7; 107), das auf einem ersten Ausrüstungsteil (1) angebracht ist, wobei das erste Ausrüstungsteil (1) ein erstes Fühmgs- und Positionierungsorgan (9) aufweist, das die relative Führung entlang einer Zusammenbaurichtung (X-X) und Positionierung des ersten elektrischen Verbindungsteils (7; 107) auf dem ersten Ausrüstungsteil (1) zulässt,
- einem zweiten Ausrüstungsteil (14) mit einem zweiten Führungs- und Positionierungsorgan (30),
- einem zweiten elektrischen Verbindungsteil (28; 122), das komplementär zu dem ersten und auf dem zweiten Ausrüstungsteil (14) angebracht ist,
**dadurch gekennzeichnet, dass** das zweite Führungs- und Positionierungsorgan komplementär zu dem ersten (9) ist und die relative Führung und Positionierung des zweiten Ausrüstungsteils auf dem ersten Ausrüstungsteil (1) zulässt, und dass das zweite elektrische Verbindungsteil (28; 122) auf dem entsprechenden Ausrüstungsteil (14) mit einem Spiel in zumindest eine praktisch senkrecht zu der Zusammenbaurichtung (X-X) liegende Richtung (Y-Y, Z-Z) angebracht ist und ein drittes Führungs- und Positionierungsorgan (32; 124) aufweist, das komplementär zu dem ersten (9) ist, so dass das erste Führungs- und Positionierungsorgan (9) einen alleinigen Bezugspunkt für die relative Positionierung der Ausrüstungsteile (1, 14) und für die relative Positionierung des ersten (7) und zweiten (28; 122) Verbindungsteils definiert.

2. Ausrüstungseinheit gemäß Anspruch 1, **dadurch gekennzeichnet, dass** das zweite Verbindungsteil (28; 122) auf dem zweiten Ausrüstungsteil (14) mit einem Spiel in zwei Richtungen (Y-Y, Z-Z) angebracht ist, die praktisch senkrecht zu der Zusammenbaurichtung (X-X) liegen.

3. Ausrüstungseinheit gemäß Anspruch 1 oder 2, **dadurch gekennzeichnet, dass** das Spiel in zumindest eine senkrecht zu der Zusammenbaurichtung (X-X) liegende Richtung größer als 1,5 mm, vorzugsweise in der Größenordnung von 2 mm ist.

4. Ausrüstungseinheit gemäß irgendeinem der Ansprüche 1 bis 3, **dadurch gekennzeichnet, dass** sie elastische Vorrichtungen (33) zum Spannen des zweiten Verbindungsteils (28; 122) zu einer neutralen Position bezüglich des zweiten Ausrüstungsteils (14) hin aufweist, welche in zumindest eine Spielrichtung (Y-Y, Z-Z) wirken.

5. Ausrüstungseinheit gemäß irgendeinem der Ansprüche 1 bis 4, **dadurch gekennzeichnet, dass** die Führungs- und Positionierungsorgane (30, 32; 124) des zweiten Ausrüstungsteils und des zweiten Verbindungsteils (28; 122) einerseits und das Führungs- und Positionierungsorgan (9) des ersten Ausrüstungsteils andererseits komplementäre Schienen sind, die sich praktisch geradlinig entlang der Kupplungsrichtung der Verbindungsteile (7; 28; 107, 122) erstrecken.

6. Ausrüstungseinheit gemäß Anspruch 5, **dadurch gekennzeichnet, dass** sich die Schiene (32; 124) des zweiten Verbindungsteils (28; 122) praktisch in der Verlängerung der Schiene (30) des zweiten Ausrüstungsteils (14) erstreckt.

7. Ausrüstungseinheit gemäß irgendeinem der Ansprüche 1 bis 6, **dadurch gekennzeichnet, dass** das zweite Verbindungsteil (28; 122) fest einstückig mit einer gedruckten Schaltplatte (20; 120) ausgebildet ist, welche selbst mit Spiel auf dem entsprechenden Ausrüstungsteil (14) angebracht ist.

8. Ausrüstungseinheit gemäß Anspruch 7, **dadurch gekennzeichnet, dass** die gedruckte Schaltplatte (20; 120) ein Ansichtsteil ist, welches vom Innenraum des Fahrzeugs aus sichtbar ist, wenn die Einheit in dem Fahrzeug angebracht ist.

9. Ausrüstungseinheit gemäß irgendeinem der Ansprüche 1 bis 8, **dadurch gekennzeichnet, dass** zumindest das eine (7, 28; 107) der Verbindungsteile ein Gehäuse ist, in welchem Kontakte (111) gelagert sind.

10. Ausrüstungseinheit gemäß Anspruch 9, **dadurch gekennzeichnet, dass** die beiden Verbindungsteile (7, 28) zueinander komplementäre Gehäuse sind, in welchen jeweils jeweilige Kontakte gelagert sind, die komplementär zu denjenigen sind, welche in dem Gegenstück (7, 28) des Verbindungsgehäuses gelagert sind.

11. Ausrüstungseinheit gemäß den Ansprüchen 7 und 9 zusammengenommen, **dadurch gekennzeichnet, dass** das eine (107) der Verbindungsteile ein Gehäuse ist, in welchem Kontakte (111) der Art Druckkontakte gelagert sind, während das andere (122) der Verbindungsteile leitende Oberflächen aufweist, die auf der gedruckten Schaltplatte (20; 120) ausgebildet sind, wobei die Flächen die Kontakte (111) der Art Druckkontakte in Auflage aufnehmen.

12. Ausrüstungseinheit gemäß Anspruch 11, **dadurch gekennzeichnet, dass** das dritte Führungs- und Positionierungsorgan (124) direkt in dem Verbindungsteil ausgebildet ist, das der gedruckten Schaltplatte (120) entspricht.
